(19) Europäisches Patentamt

European Patent Office

Office européen des brevets

(11) **EP 0 985 269 B1**

(12) **EUROPÄISCHE PATENTSCHRIFT**

(45) Veröffentlichungstag und Bekanntmachung des Hinweises auf die Patenterteilung:
**18.07.2001   Patentblatt 2001/29**

(21) Anmeldenummer: **98910691.9**

(22) Anmeldetag: **17.02.1998**

(51) Int Cl.$^7$: **H03H 7/48**

(86) Internationale Anmeldenummer:
**PCT/EP98/00894**

(87) Internationale Veröffentlichungsnummer:
**WO 98/54835 (03.12.1998 Gazette 1998/48)**

(54) **HOCHENTKOPPELTES HOCHFREQUENZ-VERTEILNETZ**

HIGHLY DECOUPLED HIGH-FREQUENCY DISTRIBUTION NETWORK

RESEAU DE DISTRIBUTION HAUTE FREQUENCE A DECOUPLAGE TRES POUSSE

(84) Benannte Vertragsstaaten:
**AT CH DE ES FR IT LI**

(30) Priorität: **30.05.1997   DE 19722792**

(43) Veröffentlichungstag der Anmeldung:
**15.03.2000   Patentblatt 2000/11**

(73) Patentinhaber: **Hirschmann Electronics GmbH & Co. KG
72654 Neckartenzlingen (DE)**

(72) Erfinder:
• **MAIER, Hartmut
D-73760 Ostfildern (DE)**
• **WENDEL, Wolfgang
D-73257 Köngen (DE)**
• **EPPLE, Ralf
D-73669 Lichtenwald (DE)**
• **PASADU, Chaiyakarn
D-73240 Wendlingen (DE)**

(74) Vertreter: **Stadler, Heinz, Dipl.-Ing.
Weikersheimer Strasse 17
70435 Stuttgart (DE)**

(56) Entgegenhaltungen:
**EP-A- 0 225 461          DE-A- 1 616 405**

## Beschreibung

Die Erfindung betrifft ein Hochfrequenz-Verteilnetz gemäß dem Oberbegriff des Patentanspruches 1. Derartige Verteilnetze sind vor allem von Satelliten-Empfangsanlagen zur Übertragung direkt empfangener, in den 1. Satelliten-Zwischenfrequenzbereich (0,95 bis 2,05 GHz) umgesetzter und in diesem Frequenzbereich verteilter Signale bekannt. Sie kommen aber beispielsweise auch bei Breitband-Kabelnetzen (CATV) für die Signalübertragung im VHF- und UHF-Bereich vor, wenn etwa zusätzlich zu den Kabelkanälen ein nicht über diese geliefertes Programm (z.B. den Schweizerischen TV-Kanal 7) über einen zweiten Signalübertragungszweig in ein Hochfrequenzgerät, z.B. einen Verstärker, eingespeist wird, in welchem dann die beiden Zweige verkoppelt sind.

Die Verkopplung erfolgt sowohl über mechanische Bauelemente wie z.B. Anschlußklemmen als auch durch elektrische Komponenten, etwa Pin-Dioden bei Multischaltern oder auch Leiterbahnen von elektrischen Schaltungsplatinen (Verkopplungsquellen).

Sie führt dazu, daß auf jedem Signalübertragungszweig auch die um die jeweilige Koppeldämpfung verminderten Signale des anderen Zweigs als Störsignale mitübertragen werden. Je geringer diese Koppeldämpfung (Entkopplung) ist, um so stärker wirkt sich die Störung aus. Am größten ist die Störwirkung, wenn über beide Zweige Signale frequenzgleicher Kanäle übertragen werden. Dies ist etwa bei gleichzeitigem Empfang von ASTRA- und EUTELSAT-Signalen der Fall. Hier sollte die Koppeldämpfung zwischen den Zweigen wenigstens 16 dB betragen um einen ausreichenden Störabstand zu gewährleisten.

Bei über beide Zweige übertragenenen ASTRA-Signalen (horizontale und vertikale Polarisation) ist dagegen aufgrund von deren genormtem Frequenzversatz die Übertragungsqualität noch bei einer Entkopplung von etwa 13 dB ausreichend.

Die genannten, für den Satellitenempfang im 1. Satelliten-Zwischenfrequenzbereich geltenden Entkopplungswerte werden bei der Verkopplung in nur einem Hochfrequenzgerät, z.B. einem Multischalter, einem Einschleus- oder Nachverstärker oder auch einer passiven Einrichtung wie z.B. einer Teilnehmer-Anschlußdose, in aller Regel erreicht oder übertroffen. In der Praxis verwendete Hochfrequenz-Verteilnetze der eingangs genannten Art enthalten indessen zumeist mehrere, manchmal sogar eine Vielzahl kaskadierter derartiger Geräte. Dieser Fall wird durch die wachsende Tendenz zu großen Netzen zukünftig noch häufiger werden.

Durch jedes kaskadierte Hochfrequenz-Gerät wird durch deren Verkopplungsquellen die Entkopplung der Signalübertragungszweige voneinander verschlechtert, am stärksten, nämlich um 6 dB, wenn die Koppeldämpfung in aufeinanderfolgenden Hochfrequenz-Geräten den gleichen Betrag aufweist. In diesem Fall werden schon bei drei hintereinander geschalteten Geräten selbst bei ausschließlichem Empfang von ASTRA-Signalen die für einen störungsfreien Empfang geforderten Entkopplungswerte an den Teilnehmeranschlüssen unterschritten.

Bei terrestrischem Empfang, z.B. dem oben beschriebenen Fall der Einschleusung eines zusätzlichen VHF-Signals in ein BK-Netz, ist der vorgeschriebene Störabstand noch höher (60 dB) und sollte für in der Praxis gerade noch brauchbaren Empfang wenigstens annähernd diesen Wert erreichen. Die Geräte weisen zwar in diesem tieferen Frequenzbereich höhere Koppeldämpfungen von > etwa 50 dB auf, bereits bei einer Kaskadierung von zwei Geräten kann aber auch hier der Störabstand zu gering sein.

Es ist bereits bekannt, die störende Verkopplung einzelner Schaltungsteile von Hochfrequenzgeräten durch Abschirmeinrichtungen wie metallische Trennwände oder vollständige Kammern und geschirmte Hochfrequenz-Leitungen sowie die Anwendung der Multilayer-Technik zu verringern. Damit ist zwar bei Hochfrequenz-Verteilnetzen ohne geschaltete Hochfrequenzgeräte eine ausreichende Entkopplung auch bei vielen kaskadierten Geräten erzielbar. Diese Maßnahmen sind jedoch aufwendig und teuer, so daß ihre Anwendung insbesondere bei großen Empfangsanlagen aus Kostengründen meist nicht mehr akzeptabel ist.

Bei Verteilnetzen mit Schaltern, z.B. Multischaltern in Satelliten-Verteilnetzen, würde jedoch selbst ein Aufbau der Hochfrequenzgeräte in der besonders aufwendigen Kammertechnik nur die Hintereinanderschaltung von wenigen Geräten ermöglichen, wenn die geforderte Koppeldämpfung zwischen den Singalübertragungszweigen gewährleistet werden soll. Für größere Netze ist selbst dieser teure Aufbau nicht mehr ausreichend. Der gewünschten Kaskadierbarkeit bzw. Netzgröße (Systemreichweite) sind somit enge Grenzen gesetzt.

Aufgabe der vorliegenden Erfindung ist es daher, ein Hochfrequenz-Verteilnetz der eingangs genannten Art auf möglichst einfache und kostengünstige Weise derart weiterzubilden, daß auch bei Einsatz von Schaltern und/oder einer Vielzahl von kaskadierten Hochfrequenz-Geräten eine ausreichende Entkopplung der Signalübertragungszweige voneinander gewährleistet ist.

Diese Aufgabe ist durch die kennzeichnenden Merkmale des Anspruches 1 gelöst.

Die Wirkungsweise dieser Merkmale wird im folgenden anhand eines einfachen Beispiels mit zwei Signalübertragungszweigen (ein Paar) erläutert, in die zwei Hochfrequenz-Geräte hintereinander eingeschaltet sind. An den beiden Eingängen liegen die Signale $U_1$ bzw. $U_2$ an, die Hochfrequenzgeräte weisen Kopplungsfaktoren $k_1$ und $k_2$ auf. Aufgrund der gegenseitigen Verkopplung entstehen am Ausgang des ersten Hochfrequenzgerätes die Spannungen $U_1 + k_1 \cdot U_2$ bzw. $U_2 + k_1 \cdot U_1$.

Ohne Phasendrehglied liegen dann am Ausgang des kaskadierten zweiten Hochfrequenzgerätes die Spannungen

$U_1 (1 + k_1 k_2) + U_2 (k_1 + k_2)$ bzw. $U_2 (1 + k_1 k_2) + U_1 (k_1 + k_2)$ an. Ersichtlich nimmt also die störende Verkopplung an den Ausgängen zu, der Störabstand verschlechtert sich mit steigendem Kaskadierungsgrad immer mehr.

Ist jedoch erfindungsgemäß ein 180°-Phasendrehglied in einen der beiden Signalübertragungszweige zwischen den beiden Hochfrequenzgeräten eingeschaltet, so gelangt die Ausgangsspannung des ersten Hochfrequenzgerätes mit negativem Vorzeichen an den entsprechenden Eingang des zweiten Hochfrequenzgerätes und wird darin auf den anderen Signalübertragungszweig gekoppelt. An den Ausgängen des zweiten Hochfrequenzgerätes entstehen jetzt die Signale

$$U_1 (1-k_1 k_2) + U_2 (k_1 - k_2) \text{ bzw. } U_2 (1 - k_1 k_2) + U_1 (k_1 - k_2).$$

Man erkennt, daß der Störanteil des jeweils anderen Signalübertragungszweiges aufgrund des Faktors $(k_1 - k_2)$ zumindest verringert, für den relativ häufigen Fall gleicher Hochfrequenzgeräte, bei denen die beiden Kopplungsfaktoren gleich groß sind, sogar vollständig eliminiert ist.

Die aufgezeigte Kompensationswirkung ist um so besser, je mehr kaskadierte Hochfrequenzgeräte eine nach Betrag und Phase möglichst gleiche gegenseitige Verkopplung der angeschlossenen beiden Signalübertragungszweige aufweisen. Dies ist z.B. bei Satellitenempfangsanlagen auch mit größeren Verteilnetzen in hohem Maße der Fall, weil die darin verwendeten Hochfrequenzgeräte wie Multischalter, Einschleus-und Nachverstärker sowie Teilnehmer-Anschlußdosen gleiche Verkopplungsquellen aufweisen.

Wie viele solcher Phasendrehglieder erforderlich sind, hängt auch davon ab, wie hoch die Koppeldämpfung zwischen den Signalübertragungszweigen in den einzelnen Hochfrequenzgeräten ist. Wenn beispielsweise einem Empfangskonverter (LNC) mit einer Koppeldämpfung von etwa 18 dB zwischen den auf den beiden Singalübertragungszweigen übertragenen horizontal bzw vertikal polarisierten Satellitensignalen ein Kopfstellenverstärker mit einer Entkopplung von ebenfalls 18 dB nachgeschaltet ist, so beträgt die Koppeldämpfung an dessen Ausgang nur noch etwa 12 dB. Weist der Verstärker jedoch eine Koppeldämpfung von z.B. 25 dB auf, so sinkt die Ausgangsentkopplung nur um etwa 2 dB auf ca. 16 dB ab, womit noch ein störungsfreier Empfang auch von nicht frequenzversetzten Signalen möglich ist.

Schließlich hängt die Anzahl der nötigen Phasendrehglieder auch von der Zahl der in den Hochfrequenzgeräten verkoppelten Signalübertragungszweige ab.

In allen Anwendungsfällen ist der Aufwand minimiert, wenn jeweils dann ein 180°-Phasendrehglied vorgesehen ist, wenn die einen gerade noch störungsfreien Empfang gewährleistende minimale gegenseitige Entkopplung der Signalübertragungszweige erreicht ist. Im Vergleich zu den bekannten teuren Maßnahmen zur Erhöhung der Entkopplung - wie Multilayer- und Kammertechnik - sind durch das erfindungsgemäße Einschalten kostengünstiger 180°-Phasendrehglieder auf einfachste Weise nicht nur sehr viel kostengünstigere Hochfrequenzverteilnetze realisierbar, sondern überdies die störenden Verkopplungen zwischen den Signalübertragungszweigen so kompensierbar, daß theoretisch beliebig große Netze mit kaskadierten, auch geschalteten Hochfrequenzgeräten wie Multischaltern aufgebaut und insoweit störungsfrei betrieben werden können.

In den Unteransprüchen sind vorteilhafte Ausführungen des erfindungsgemäßen Hochfrequenzr-Verteilnetzes und Ausbildungen der 180°-Phasendrehglieder angegeben.

Ein nach Anspruch 2 aufgebautes Hochfrequenz-Verteilnetz ermöglicht bei einem Einsatz von nur zwei in jedem Hochfrequenzgerät angeschlossenen Signalübertragungszweigen auch dann ausreichende Entkopplungswerte und damit einen störungsfreien Empfang, wenn die zu kaskadierenden Hochfrequenzgeräte selbst ungünstige Koppeldämpfungen aufweisen. Da derartige Geräte in der Regel billiger sind als solche mit hoher Entkopplung der Signalübertragungszweige, ist bei Wahl kostengünstiger Phasendrehglieder trotz deren hoher Zahl das genannte Verteilnetz mit noch geringeren Kosten realisierbar.

Hochfrequenz-Verteilnetze mit zwei oder gar noch mehr Paaren von Signalübertragungszweigen sind erst durch einen Aufbau gemäß Anspruch 2 mit einer ausreichenden Störsignalkompensation betreibbar.

Durch eine Anordnung der 180°-Phasendrehglieder nach Anspruch 3 ist bei zwei oder mehr Paaren von Signalübertragungszweigen eine insgesamt gleichstarke Kompensation der Paare erzielt.

Außerdem hätten - wenn die Phasendrehglieder z.B. als Halbwellen-Leitungsstücke ausgebildet sind - die Signalübertragungszweige ohne diese alternierende Einschaltung der Phasendrehglieder unterschiedliche Längen, die bei tieferen Frequenzen und großen Verteilnetzen störende Unterschiede der Durchgangsdämpfung bewirken könnten (z.B. durch unterschiedlich hohe Verstärkereingangspegel). Durch den Aufbau gemäß Anspruch 3 ist dies ohne den geringsten Mehraufwand vermieden.

Eine weitere vorteilhafte Ausführung des erfindungsgemäßen Hochfrequenz-Verteilnetzes ist in Anspruch 4 angegeben. Die abwechselnd in den zweiten bzw. dritten Signalübertragungszweig eingeschalteten 180°-Phasendrehglieder entfalten gegenüber dem unmittelbar benachbarten Zweigen die volle Kompensationswirkung. Im Verhältnis zu dem jeweils übernächsten Zweig ist diese zwar geringer, was sich jedoch nicht nachteilig auswirkt, weil auch die Koppeldämpfung zwischen diesen Zweigen aufgrund ihres größeren gegenseitigen Abstands geringer ist.

Durch diesen Aufbau ist also mit äußerst geringem Aufwand fast die gleiche Störverminderung erzielt, wie es mit der Einschaltung von Phasendrehgliedern in allen Signalübertragungszweigen möglich ist.

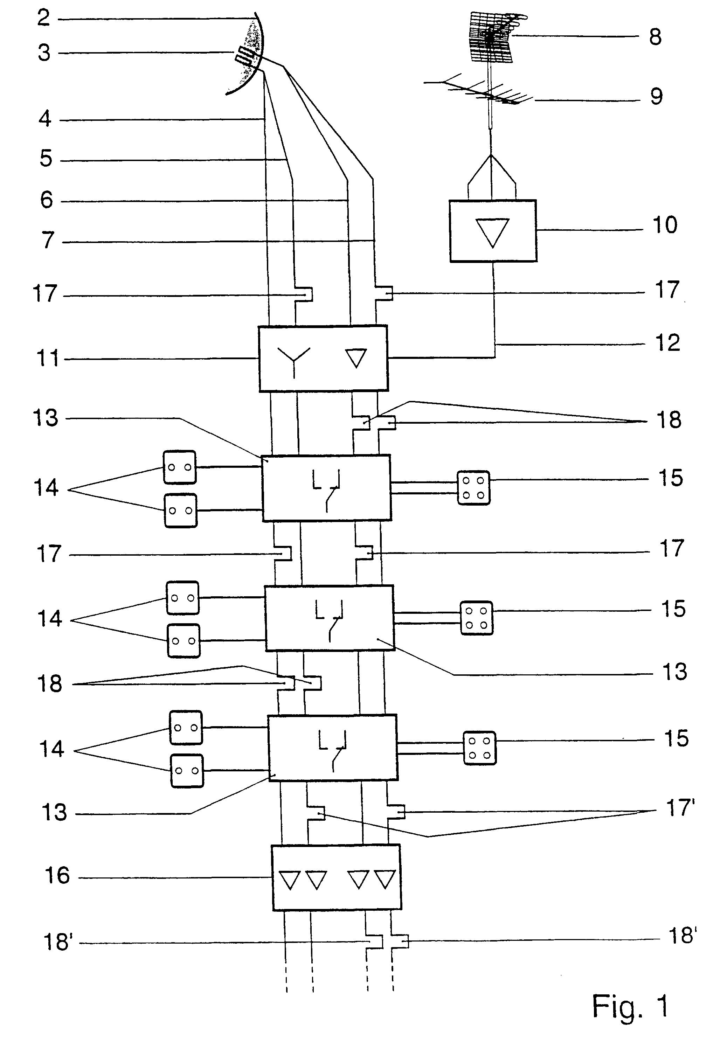

In Anspruch 5 ist eine besonders vorteilhafte Ausgestaltung eines Hochfrequenz-Verteilnetzes beschrieben, bei der zwar ein höherer Aufwand an Phasendrehgliedern vorgesehen, jedoch durch die besondere Anordnung von Phasendrehglieder-Paaren eine optimale Störkompensation erreichbar ist. Die Funktion dieser Einrichtung ist unten im Ausführungsbeispiel gemäß Fig. 1 näher beschrieben. In einem derartigen Verteilnetz sind ohne weiteres auch hinsichtlich ihrer Entkopplung ungünstige und damit in der Regel billigere Hochfrequenzgeräte einsetzbar.

In den Ansprüchen 6 bis 13 sind verschiedene Ausführungen der 180°-Phasendrehglieder aufgeführt, die sich jeweils für spezielle Anwendungsfälle besonders eignen. So ist beispielsweise die Ausbildung als Übertrager mit einem Übersetzungsverhältnis von 1 : 1 aufgrund der gegenüber einem Halbwellen-Leitungsstück kleinen Abmessungen besonders für den Einsatz bei tiefen Frequenzen und insbesondere auch für den Einbau in die Hochfrequenzgeräte selbst geeignet. Der Geräteeinbau ist häufig auch deswegen von Vorteil, weil in der Praxis in vielen Anwendungsfällen die Hochfrequenzgeräte durch direktes Zusammenstecken mittels koaxialer Gerätesteckverbinder kaskadiert werden. Außerdem sind derartige Übertrager als SMD-Bauteile kostengünstig herstell- und montierbar. In vielen Fällen ist darüberhinaus die relativ große Breitbandigkeit von besonderem Vorteil.

Eine Phasendrehung um 180° ist gemäß den Ansprüchen 8 und 9 auch durch Verkürzung oder Verlängerung eines Signalübertragungszweiges realisierbar. Dies ist nicht nur bei neu aufzubauenden Verteilnetzen möglich, sondern stellt insbesondere eine gute Möglichkeit für die nachträgliche Entkopplungsverbesserung bereits bestehender Hochfrequenz-Verteilnetze dar.

Im Falle der Verlängerung eines Signalübertragungszweiges ist es besonders vorteilhaft, wenn diese gemäß Anspruch 10 bereits als vorgefertigtes Verlängerungsstück vorliegt, das nur noch in die Leitung eingefügt werden muß. Dies ist besonders schnell und einfach möglich, wenn gemäß Anspruch 11 sowohl die Halbwellen-Kabelstücke als auch die Einfügungsstellen (also beispielsweise der Geräteausgang und ein daran anzuschließendes Kabel) mit passenden Steckverbindern ausgerüstet sind.

Das Halbwellenstück kann gemäß Anspruch 12 bzw. 13 als Kabelstück oder als gedruckte Leitung ausgebildet sein. Während letztere praktisch nur für den Einsatz im Innern der Gerätegehäuse in Betracht kommen, sind Kabelstücke für die Montage sowohl außerhalb der Hochfrequenzgeräte als (insbesondere bei hohen Frequenzen und damit in geringen Längen) auch im Gehäuseinnern geeignet.

Die Koppeldämpfung zwischen den Signalübertragungszweigen ist z.B. im 1. Satelliten-Zwischenfrequenzbereich weder konstant noch wird sie mit wachsender Frequenz stetig geringer. Sie weist vielmehr in dem genannten Frequenzbereich ein Minimum auf, das im genannten Beispiel eines SatellitenVerteilnetzes nicht in Bandmitte sondern bei etwa 1,7 GHz liegt.

Selbstverständlich beträgt auch die Phasendrehung der Phasendrehglieder nicht über den gesamten Frequenzbereich 180° sondern streng genommen nur bei einer einzigen Frequenz.

Es ist daher besonders vorteilhaft, gemäß den Merkmalen des Anspruches 14 die Phasendrehglieder so zu bemessen, daß ihre stärkste Kompensationswirkung der genannten Frequenz von 1,7 GHz zugeordnet sind.

Die Kompensationswirkung der Phasendrehglieder - auch bei Ausgestaltung als Übertrager - wird insbesondere bei großen Betriebsfrequenzbereichen wie dem ersten Satelliten-Zwischenfrequenzbereich zu den Bereichsgrenzen hin zunehmend geringer.

Eine Verbesserung der Systembandbreite ist in vorteilhafter Weise ohne großen Aufwand nach Anspruch 15 dadurch erreichbar, daß die Phasendrehglieder auf unterschiedliche Frequenzen des Betriebsfrequenzbereichs abgestimmt sind. Besonders zweckmäßig sind dabei etwa gleiche Abstände ober- und unterhalb der genannten Frequenz, bei der die Koppeldämpfung ein Minimum beträgt.

Die Erfindung wird nachfolgend noch anhand zweier Ausführungsbeispiele näher erläutert. Dabei zeigen

Fig. 1 -    ein Blockschaltbild einer Empfangsanlage für Satelliten- und terrestrische Signale mit einem antennenseitigen Teil des Hochfrequenz-Verteilnetzes und

Fig. 2 -    ein Blockschaltbild eines Teils eines Hochfrequenz-Verteilnetzes für die Verteilung von Satellitensignalen auf nicht dargestellte Teilnehmer, mit einer minimalen Anzahl von Phasendrehgliedern.

Die Empfangsanlage 1 gemäß Fig. 1 enthält als Hochfrequenz-Verteilnetz ein Vier-Kabelsystem mit Etagen-Sternverteilung.

Sie weist eingangsseitig eine Satellitenempfangsantenne 2 mit einem Doppel-Konverter 3 (inklusive Polarisationsweiche) zum Empfang der horizontal und vertikal polarisierten Signale eines ASTRA- und eines EUTELSAT-Satelliten, deren Verstärkung, Frequenzumsetzung in den 1. Satelliten-Zwischenfrequenzbereich (0,95 bis 2,05 GHz) und Weiterleitung über vier Kabel 4 bis 7 (Signalübertragungszweige) sowie je eine UHF- und eine VHF-Antenne 8, 9 zum Empfang terrestrisch ausgestrahlter Rundfunk- und Fernsehprogramme mit nachgeschaltetem Breitbandverstärker 10 auf

Die über die Kabel 4 bis 7 übertragenen jeweils horizontal und vertikal polarisierten ASTRA- bzw. EUTELSAT-Satellitensignale werden in einem Einschleusverstärker 11 der Kopfstelle des Vier-Kabelsystems verstärkt. Zugleich werden darin die über ein weiteres Kabel 12 herangeführten terrestrischen Ausgangssignale des Breitbandverstärkers 10 auf die Stammleitungen 4 bis 7 eingeschleust.

Dem Einschleusverstärker sind drei Multischalter 13 in Kaskade nachgeschaltet, von denen aus jeweils drei Teilnehmer-Anschlußdosen 14, 15 in jeder Etage eines Hochhauses versorgt werden.
Die Teilnehmer-Anschlußdosen 14 sind dabei nur für Satellitenempfang vorgesehen, während an den Teilnehmer-Anschlußdosen 15 sowohl Satelliten- als auch terrestrische Programme im VHF-/UHF-Bereich (z.B. UKW-Rundfunk und TV in UHF-Kanälen) empfangen werden können.

Diesem Verteilnetzblock ist wenigstens ein weiterer prinzipiell gleicher Block, bestehend aus einem Nachverstärker 16 zum Ausgleich der Dämpfungsverluste im Verteilnetz des vorangegangenen Blocks und drei (nicht dargestellte) Multischaltern mit zugehörigen Teilnehmeranschlußdosen nachgeschaltet. Die Teilnehmer können über die Multischalter 13 unabhängig voneinander durch Wahl des 0/22 KHz-Schaltsignals ihrer Satellitenempfänger die ASTRA- oder EUTELSAT-Programme und durch Wahl der 13/18 Volt-Versorgungsspannung des Doppelkonverters 3 jeweils die horizontal oder vertikal polarisierten Signale empfangen.

Zur erfindungsgemäßen Kompensation der Verkopplungen in den Geräten 3, 11, 13 und 16 sind 180°-Phasendrehglieder 17 in der nachfolgend erläuterten Weise in die vier Signalübertragungszweige 4 bis 7 eingeschaltet. Sie sind in Fig. 1 schematisch als Kabelverlängerungsstücke außerhalb der Geräte dargestellt, können jedoch - wie bereits beschrieben - selbstverständlich auch innerhalb der Geräte angeordnet und nicht nur in Form von Verlängerungsstücken sondern beispielsweise auch als Übertrager mit einem Übersetzungsverhältnis von 1 : 1 ausgebildet sein.

Am Eingang der Kopfstelle, also zwischen Doppelkonverter 3 und Einschleusverstärker 11, sowie zwischen dem ersten und zweiten Multischalter 13 ist in einen Signalübertragungszweig jedes der die horizontal bzw vertikal polarisierten Signale eines Satelliten (ASTRA bzw. EUTELSAT) übertragenen Kabelpaare 4, 5 bzw 6, 7 ein Phasendrehglied eingeschaltet, welches in der bereits beschriebenen Weise die Störwirkung der Verkopplungen im ASTRA- und im EUTELSAT-Konverter sowie im ersten, dem Einschleusverstärker 11 nachgeschalteten Multischalter 13 beseitigt oder zumindest wesentlich vermindert.

Innerhalb des Einschleusverstärker 11 und der nachgeschalteten Multischalter 13 treten durch das Vier-Kabelsytem jedoch nicht nur Verkopplungen zwischen den beiden Zweigen jedes Paars von Signalübertragungszweigen (z.B. für die Übertragung von horizontal und vertikal polarisierten ASTRA-Signalen), sondern auch Kreuzverkopplungen zwischen den Paaren, also Verkopplungen von ASTRA und EUTELSAT-Signalen auf. Diese Verkopplung wird erfindungsgemäß dadurch weitgehend kompensiert, daß zwischen dem Einschleusverstärker 11 und dem ersten nachfolgenden Multischalter 13, sowie zwischen dem zweiten und dritten nachfolgenden Multischalter 13 jeweils in beide Signalübertragungszweige 6, 7 bzw 4, 5 eines der beiden Paare ein 180°-Phasendrehglied eingeschaltet ist. Die Funktionsweise der Kompensation der störenden Kreuzverkopplung entspricht dabei im Prinzip der bereits im Zusammenhang mit der Verminderung der Verkopplung der beiden Zweige eines Paares beschriebenen.

Die Kompensation der beiden Verkopplungen erfolgt somit durch Einschaltung jeweils zweier Phasendrehglieder der genannten Art zwischen je zwei Geräten, und zwar in alternierender Reihenfolge einmal je eines Phasendrehgliedes in einen Zweig jedes Kabelpaares und dann in die beiden Zweige eines Kabelpaares.
Dabei ist es grundsätzlich unerheblich, in welchen der beiden Zweige bzw. in welches der beiden Kabelpaare die beiden Phasendrehglieder eingesetzt werden. Im vorliegenden Ausführungsbeispiel ist dies ebenfalls abwechselnd in den jeweils anderen Zweigen bzw. Paaren vorgenommen (Anspruch 3), wodurch in vorteilhafter Weise insbesondere eine gleichstarke Störkompensation der ASTRA- und EUTELSAT-Signale erreicht wird.

Die beschriebenen Kompensationsmaßnahmen erfolgen somit in einem Zyklus von vier aufeinanderfolgend kaskadierten Hochfrequenzgeräten. Der nächste Zyklus beginnt mit den zwischen dem dritten Multischalter 13 und dem Nachverstärker 16 in je einen Zweig 5, 7 jedes Kabelpaars 4, 5 bzw. 6, 7 eingeschalteten Phasendrehglied 17' und setzt sich in der gleichen Weise fort wie beim ersten Zyklus. Das heißt, dem Nachverstärker 16 ist in beiden Zweigen 6, 7 ein Phasendrehglied 18' nachgeschaltet usw.

Dieses Hochfrequenz-Verteilnetz ist zwar durch die vielen Phasendrehglieder verhältnismäßig aufwendig, kann damit jedoch theoretisch beliebig lang gemacht werden, ohne daß sich die Signalverkopplungen in den Hochfrequenzgeräten - auch bei Verwendung von billigen Geräten mit niedrigen Entkopplungswerten von z.B. nur 18 dB - störend auswirken. Aufgrund dieser hohen Systemreichweite können im vorliegenden Ausführungsbeispiel 24 Teilnehmer in 8 Etagen eines Hochhauses versorgt werden, wobei die gemessene Entkopplung mit wenigstens 17 dB größer ist als der für den Empfang von ASTRA- und EUTELSAT-Signalen erforderliche Wert von 16 dB.

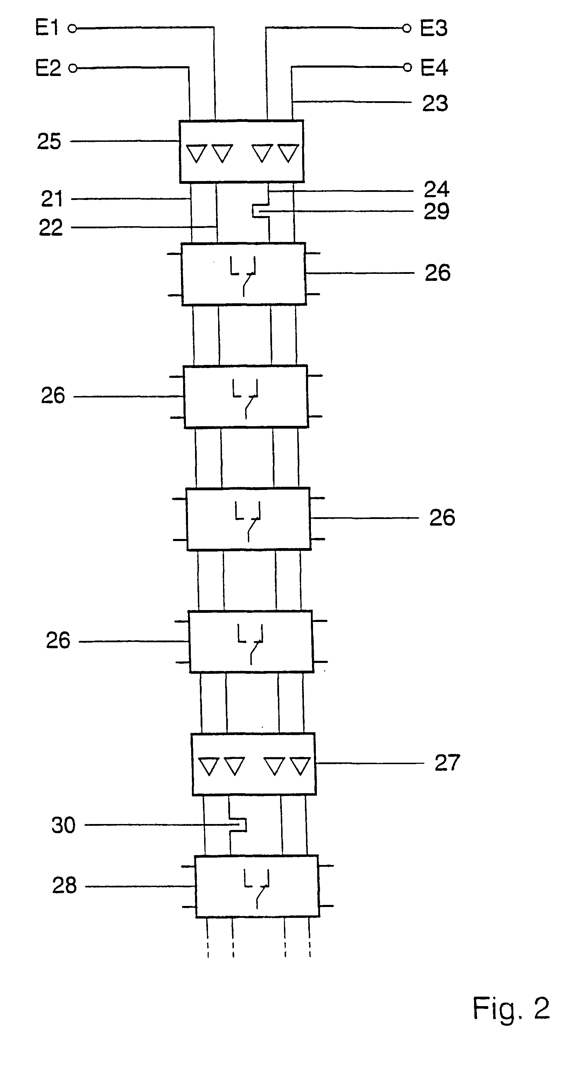

Die in Fig. 2 dargestellte Empfangsanlage 20 weist ebenfalls ein Vier-Kabelsystem mit Etagen-Sternverteilung auf, jedoch nur zum Empfang von Satellitenprogrammen.

An den Eingängen E1, E2 liegen die in den 1. Satelliten-Zwischenfrequenzbereich umgesetzten horizontal bzw vertikal polarisierten ASTRA-Signale an, an den Eingängen E3, E4 die entsprechenden EUTELSAT-Signale. Sie werden über vier Kabel 21 bis 24 einem Kopfstellen-Verstärker 25 zugeführt, dem vier kaskadierte Multischalter 26 zum Anschuß von jeweils vier, insgesamt also 16 Teilnehmern nachgeschaltet sind.

Auf diese erste cHochfrequenz-Gerätegruppe folgt eine zweite, ebenfalls aus einem Verstärker 27 und vier hintereinandergeschalteten Multischaltern 28 bestehende Gerätegruppe.

Zwischen dem Verstärker 25 bzw. 27 und dem ersten Multischalter 26 bzw 28 jeder Gerätegruppe ist in einen der beiden mittleren Signalübertragungszweige 23 bzw. 22 ein 180°-Phasendrehglied 29 bzw. 30 eingeschaltet. Sowohl die Verstärker 25, 27 also auch die Multischalter 26, 28 weisen durch einen entsprechenden Aufbau (aber ohne teure Multilayer- und/oder Kammertechnik) günstige Entkopplungswerte von ca. 25 dB auf. Die Gesamtentkopplung vermindert sich dadurch je Gerät nur um 2 dB. Damit ist es möglich, für jeweils fünf kaskadierte Hochfrequenzgeräte nur ein einziges Phasendrehglied einzusetzen und damit trotzdem einen ausreichenden Störabstand für alle Teilnehmer zu gewährleisten.

Bei diesem Hochfrequenz-Verteilnetz ist also mit einem Minimum an Aufwand eine maximale Verminderung der Störwirkung aufgrund von in den Hochfrequenzgeräten verkoppelten Satellitenfrequenzsignalen erreicht.

Auch bei diesem Ausführungsbespiel sind die in den Ansprüchen 3, 4, 14 und 15 angeführten vorteilhaften Ausgestaltungen angewendet, wodurch eine gleiche Kompensation der störenden Verkopplungen in beiden Kabelpaaren 21, 22 und 23, 24 erfolgt und die Kompensationswirkung breitbandiger ist.

## Patentansprüche

1. Hochfrequenz-Verteilnetz (1; 20) zum Übertragen von Hochfrequenz-Signalen auf wenigstens einen Teilnehmer (14, 15), mit wenigstens einem Paar von in zumindest einem daran angeschlossenen Hochfrequenzgerät (3, 11, 13, 16, 25 bis 28) miteinander verkoppelten Signalübertragungsweigen (4 bis 7; 21 bis 24), **dadurch gekennzeichnet,** daß in wenigstens einem Signalübertragungszweig (4 bis 7; 22 bis 24) jedes Paars (4/5, 6/7; 21/22, 23/24) wenigstens ein Phasendrehglied (17, 17', 18, 18'; 29, 30) eingeschaltet ist, welches die Phase der darauf übertragenen Hochfrequenz-Nutz- und -Störsignale um etwa 180° gegenüber denen des anderen Signalübertragungszweigs des Paars dreht.

2. Hochfrequenz-Verteilnetz nach Anspruch 1, dadurch gekennzeichnet, daß in jedem Paar (4/5, 6/7) von Signalübertragungszweigen (4 bis 7) nach jedem der hintereinandergeschalteten Hochfrequenzgeräte (3, 11, 13, 16) wenigstens ein Phasendrehglied (17, 17', 18, 18') vorgesehen ist.

3. Hochfrequenz-Verteilnetz nach Anspruch 1 oder 2, dadurch gekennzeichnet, daß aufeinanderfolgende Phasendrehglieder (17, 17', 18, 18'; 29, 30) abwechselnd in unterschiedlichen Signalübertragungszweigen eingeschaltet sind.

4. Hochfrequenz-Verteilnetz nach Anspruch 3 mit zwei Paaren von Signalübertragungszweigen dadurch gekennzeichnet, daß lediglich in die beiden mittleren Signalübertragungszweige (22, 24) Phasendrehglieder (30, 29) eingeschaltet sind.

5. Hochfrequenz-Verteilnetz nach Anspruch 1 oder 2 mit zwei Paaren von Signalübertragungszweigen, dadurch gekennzeichnet, daß zwischen je zwei aufeinanderfolgenden Hochfrequenzgeräten (3, 11, 13, 16) ein Phasendrehglied abwechselnd in je einem ersten Signalübertragungszweig (5, 7) jedes Paars, in beiden Signalübertragungszweigen (6, 7) eines ersten Paars, in je einem zweiten Signalübertragungszweig (4, 6) jedes Paars und in beiden Signalübertragungszweigen (4, 5) des zweiten Paars eingeschaltet ist.

6. Hochfrequenz-Verteilnetz nach einem der Ansprüche 1 bis 5, dadurch gekennzeichnet, daß die Phasendrehglieder als Hochfrequenz-Übertrager mit einem Übersetzungsverhältnis von 1:1 ausgebildet sind.

7. Hochfrequenz-Verteilnetz nach einem der Ansprüche 1 bis 5, dadurch gekennzeichnet, daß die Phasendrehglieder als Allpässe ausgebildet sind.

8. Hochfrequenz-Verteilnetz nach einem der Ansprüche 1 bis 5, dadurch gekennzeichnet, daß als Phasendrehglied ein etwa um eine halbe Wellenlänge verkürzter Signalübertragungszweig vorgesehen ist.

**EP 0 985 269 B1**

9. Hochfrequenz-Verteilnetz nach einem der Ansprüche 1 bis 5, dadurch gekennzeichnet, daß als Phasendrehglied ein etwa um eine halbe Wellenlänge verlängerter Signalübertragungszweig vorgesehen ist.

10. Hochfrequenz-Verteilnetz nach Anspruch 9, dadurch gekennzeichnet, daß die Verlängerung als gesondertes Halbwellenstück ausgebildet ist.

11. Hochfrequenz-Verteilnetz nach Anspruch 10, dadurch gekennzeichnet, daß das Halbwellenstück und die Einfügungsstellen der Signalübertragungszweige mit Steckverbindern ausgerüstet sind.

12. Hochfrequenz-Verteilnetz nach Anspruch 10 oder 11, dadurch gekennzeichnet, daß das Halbwellenstück ein Kabelstück ist.

13. Hochfrequenz-Verteilnetz nach Anspruch 10 oder 11, dadurch gekennzeichnet, daß das Halbwellenstück als gedruckte Leitung ausgebildet ist.

14. Hochfrequenz-Verteilnetz nach einem der Ansprüche 8 bis 13, dadurch gekennzeichnet, daß für die Bemessung der halben Wellenlänge diejenige Frequenz innerhalb des Betriebsfrequenzbereiches gewählt ist, bei der die Koppeldämpfung zwischen den Signalübertragungszweigen eines Paars ohne Phasendrehung ein Minimum ist.

15. Hochfrequenz-Verteilnetz nach einem der Ansprüche 8 bis 14 mit wenigstens zwei Phasendrehgliedern, dadurch gekennzeichnet, daß für die Bemessung der halben Wellenlänge für die einzelnen Phasendrehglieder unterschiedliche Frequenzen innerhalb des Betriebsfrequenzbereichs gewählt sind.

**Claims**

1. Radio-frequency distribution network (1; 20) for transmitting radio-frequency signals to at least one subscriber (14, 15), having at least one pair of signal transmission paths (4 to 7; 21 to 24) which are coupled to one another in at least one radio-frequency appliance (3, 11, 13, 16, 25 to 28) connected thereto, characterized in that at least one phase shifting element (17, 17', 18, 18'; 29, 30) is connected in at least one signal transmission path (4 to 7; 22 to 24) of each pair (4/5, 6/7; 21/22, 23/24), which phase-shifting element (17, 17', 18, 18'; 29, 30) shifts the phase of the radio-frequency wanted and interference signals transmitted on that part through approximately 180° with respect to that of the other signal transmission path in the pair.

2. Radio-frequency distribution network according to Claim 1, characterized in that at least one phase-shifting element (17, 17', 18, 18') is provided after each of the series-connected radio-frequency appliances (3, 11, 13, 16) in each pair (4/5, 6/7) of signal transmission paths (4 to 7).

3. Radio-frequency distribution network according to Claim 1 or 2, characterized in that successive phase-shifting elements (17, 17', 18, 18', 29, 30) are connected alternately in different signal transmission paths.

4. Radio-frequency distribution network according to Claim 3 having two pairs of signal transmission paths, characterized in that phase-shifting elements (30, 29) are connected only in the two central signal transmission paths (22, 24).

5. Radio-frequency distribution network according to Claim 1 or 2 having two pairs of signal transmission paths, characterized in that a phase-shifting element is alternately connected in in each case one first signal transmission path (5, 7) of each pair, in both signal transmission paths (6, 7) of a first pair, and in in each case one second signal transmission path (4, 6) of each pair, and in both signal transmission paths (4, 5) of the second pair, between in each case two successive radio-frequency appliances (3, 11, 13, 16).

6. Radio-frequency distribution network according to one of Claims 1 to 5, characterized in that the phase-shifting elements are in the form of radio-frequency transformers with a transformation ratio of 1:1.

7. Radio-frequency distribution network according to one of Claims 1 to 5, characterized in that the phase-shifting elements are in the form of all-pass filters.

8. Radio-frequency distribution network according to one of Claims 1 to 5, characterized in that a signal transmission

7

path which has been shortened by about half a wavelength is provided as the phase-shifting element.

9. Radio-frequency distribution network according to one of Claims 1 to 5, characterized in that a signal transmission path which has been lengthened by about half a wavelength is provided as the phase-shifting element.

10. Radio-frequency distribution network according to Claim 9, characterized in that the lengthening is in the form of a separate half-wave element.

11. Radio-frequency distribution network according to Claim 10, characterized in that the half-wave element and the insertion points in the signal transmission paths are equipped with plug connectors.

12. Radio-frequency distribution network according to Claim 10 or 11, characterized in that the half-wave element is a piece of cable.

13. Radio-frequency distribution network according to Claim 10 or 11, characterized in that the half-wave element is in the form of a printed line.

14. Radio-frequency distribution network according to one of Claims 8 to 13, characterized in that the half wavelength is dimensioned by choosing that frequency within the operating frequency band at which the coupling loss between the signal transmission paths in a pair is a minimum, without any phase shift.

15. Radio-frequency distribution network according to one of Claims 8 to 14 having at least two phase-shifting elements, characterized in that different frequencies within the operating frequency band are chosen for dimensioning the half wavelength for the individual phase-shifting elements.


**Revendications**

1. Réseau de distribution à haute fréquence (1, 20) pour la transmission de signaux à haute fréquence à au moins un abonné (14, 15), comportant au moins une paire de branches (4 à 7, 21 à 24) de transmission des signaux accouplées entre elles dans au moins un appareil à haute fréquence (3, 11, 13, 16, 25 à 28) raccordé à ce réseau, caractérisé en ce que dans au moins une branche (4 à 7, 22 à 24) de transmission des signaux de chaque paire (4/5, 6/7, 21/22, 23/24) il est monté au moins un élément de rotation de phase (17, 17', 18, 18', 29, 30) qui fait tourner d'environ 180° la phase des signaux utiles et parasites à haute fréquence transmis, par rapport à l'autre branche de transmission des signaux de la paire.

2. Réseau de distribution à haute fréquence selon la revendication 1, caractérisé en ce que dans chaque paire (4/5, 6/7) de branches (4 à 7) de transmission des signaux, il est prévu au moins un élément de rotation de phase (17, 17', 18, 18') après chacun des appareils à haute fréquence (3, 11, 13, 16) montés les uns derrière les autres.

3. Réseau de distribution à haute fréquence selon la revendication 1 ou 2, caractérisé en ce que des éléments de rotation de phase (17, 17', 18, 18', 29, 30) sont montés alternativement dans différentes branches de transmission des signaux.

4. Réseau de distribution à haute fréquence selon la revendication 3 avec deux paires de branches de transmission des signaux, caractérisé en ce que des éléments de rotation de phase (30, 29) sont montés uniquement dans les deux branches centrales (22, 24) de transmission des signaux.

5. Réseau de distribution à haute fréquence selon la revendication 1 ou 2 avec deux paires de branches de transmission des signaux, caractérisé en ce que entre deux appareils à haute fréquence (3, 11, 13, 16) successifs un élément de rotation de phase est monté alternativement dans une première branche (5, 7) de transmission des signaux de chaque paire, dans les deux branches (6, 7) de transmission des signaux d'une première paire, dans une deuxième branche (4, 6) de transmission des signaux de chaque paire et dans les deux branches (4, 5) de transmission des signaux de la deuxième paire.

6. Réseau de distribution à haute fréquence selon l'une des revendications 1 à 5, caractérisé en ce que les éléments de rotation de phase sont réalisés en tant que transmetteurs à haute fréquence avec un rapport de transmission de 1 à 1.

**7.** Réseau de distribution à haute fréquence selon l'une des revendications 1 à 5, caractérisé en ce que les éléments de rotation de phase sont conçus pour toutes les fréquences.

**8.** Réseau de distribution à haute fréquence selon l'une des revendications 1 à 5, caractérisé en ce qu'il est prévu comme élément de rotation de phase une branche de transmission des signaux raccourcie d'environ une demi-longueur d'onde.

**9.** Réseau de distribution à haute fréquence selon l'une des revendications 1 à 5, caractérisé en ce qu'il est prévu comme élément de rotation de phase une branche de transmission des signaux prolongée d'environ une demi-longueur d'onde.

**10.** Réseau de distribution à haute fréquence selon la revendication 9, caractérisé en ce que le prolongement est réalisé en tant que pièce de demi-onde séparée.

**11.** Réseau de distribution à haute fréquence selon la revendication 10, caractérisé en ce que la pièce de demi-onde et les points d'insertion des branches de transmission des signaux sont équipés de connecteurs à fiches.

**12.** Réseau de distribution à haute fréquence selon la revendication 10 ou 11, caractérisé en ce que la pièce de demi-onde est un morceau de câble.

**13.** Réseau de distribution à haute fréquence selon la revendication 10 ou 11, caractérisé en ce que la pièce de demi-onde est réalisée en tant que ligne imprimée.

**14.** Réseau de distribution à haute fréquence selon l'une des revendications 8 à 13, caractérisé en ce que pour la mesure de la demi-longueur d'onde on choisit la fréquence à l'intérieur de la gamme de fréquences de service pour laquelle l'amortissement de couplage entre les branches de transmission des signaux d'une paire sans rotation de phase est minimal.

**15.** Réseau de distribution à haute fréquence selon l'une des revendications 8 à 14, avec au moins deux éléments de rotation de phase, caractérisé en ce que pour la mesure de la demi-longueur d'onde pour les différents éléments de rotation de phase on choisit différentes fréquence à l'intérieur de la gamme de fréquences de service.

2

3

8

9

4

5

6

7

10

17

17

11

12

13

18

14

15

17

17

14

15

13

18

14

15

13

17'

16

18'

18'

Fig. 1

Fig. 2